(19) Europäisches Patentamt / European Patent Office / Office européen des brevets

(11) **EP 2 801 115 B1**

(12) **FASCICULE DE BREVET EUROPEEN**

(45) Date de publication et mention de la délivrance du brevet:
**15.02.2017 Bulletin 2017/07**

(21) Numéro de dépôt: **13703141.5**

(22) Date de dépôt: **04.01.2013**

(51) Int Cl.:
*H01L 31/0232* *(2014.01)*    *G02B 5/18* *(2006.01)*

(86) Numéro de dépôt international:
**PCT/IB2013/050081**

(87) Numéro de publication internationale:
**WO 2013/102876 (11.07.2013 Gazette 2013/28)**

(54) **DISPOSITIF DE PHOTODÉTECTION**

FOTODETEKTOR

PHOTODETECTION DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.01.2012 FR 1250169**

(43) Date de publication de la demande:
**12.11.2014 Bulletin 2014/46**

(73) Titulaire: **Commissariat à l'Énergie Atomique et aux Énergies Alternatives 75015 Paris (FR)**

(72) Inventeurs:
 • **FOWLER, Daivid**
   **38950 Saint Martin Le Vinoux (FR)**
 • **ESPIAU DE LAMAESTRE, Roch**
   **38000 Grenoble (FR)**

(74) Mandataire: **Gevers & Orès**
   **41 avenue de Friedland**
   **75008 Paris (FR)**

(56) Documents cités:
**US-A1- 2004 123 895    US-A1- 2009 020 701 US-A1- 2011 019 189**

 • **AKIO MIZUTANI ET AL: "Numerical Study on Efficient Optical Switching Based on the Nonlinear Phenomenon in a Guided-Mode Resonant Grating with Kerr Medium", OPTICAL REVIEW, SPRINGER, BERLIN, DE, vol. 12, no. 4, 1 juillet 2005 (2005-07-01), pages 313-318, XP019353292, ISSN: 1349-9432, DOI: 10.1007/S10043-005-0313-6**

EP 2 801 115 B1

## Description

L'invention concerne un dispositif de photodétection et notamment un photodétecteur infrarouge.

Un tel dispositif comporte une couche de semi-conducteur absorbant présentant une épaisseur déterminée qui est utilisée pour la collection des charges photogénérées.

On connaît déjà des photodétecteurs quantiques infrarouges. Ceux-ci doivent être refroidis bien en-dessous de la température ambiante, pour minimiser voire supprimer dans le semi-conducteur, le processus de génération de porteurs, ou courant d'obscurité, qui entre en compétition avec la photo-génération de porteurs libres, ou signal utile.

La diminution de la température du détecteur est donc le moyen courant dans l'état de l'art pour maximiser le rapport signal sur bruit.

Lorsque le semi-conducteur utilisé dans le photodétecteur est du tellurure de cadmium mercure, l'épaisseur de la couche de semi-conducteur est de plusieurs micromètres, ce qui assure une absorption maximale de la lumière infrarouge.

Une diminution du volume de semi-conducteur présent dans le photodétecteur permet également de réduire le courant d'obscurité. Diminuer l'épaisseur de la couche de semi-conducteur a d'autres avantages : réduire le coût des matériaux et augmenter la vitesse de détection.

Cependant, cette diminution d'épaisseur de la couche de semi-conducteur entraîne une diminution de l'efficacité quantique du photodétecteur, ce qui n'est pas souhaitable, car cette diminution de rendement induit une diminution du rapport signal sur bruit.

C'est pourquoi, il est classique d'associer au photodétecteur une structure de concentration de photons, afin de compenser la perte de l'efficacité quantique du photodétecteur et donc, de pouvoir bénéficier de la diminution du courant d'obscurité pour obtenir le bon rapport signal sur bruit.

Cette structure peut notamment prendre la forme d'un miroir métallique structuré qui est placé sur la face arrière d'une couche semi-conductrice absorbante, de façon à obtenir un renforcement de l'absorption dans cette couche semi-conductrice.

Un tel miroir peut notamment être utilisé dans des détecteurs à puits quantiques, dans la gamme spectrale du moyen et lointain infrarouge. Référence est faite à l'article de K.W. Goossen et al, Appl. Phys. Lett. 53, 19 septembre 1988, 1027. Cet article décrit un détecteur comprenant un empilement de couches formant des puits quantiques. En incidence normale au détecteur, ce dernier n'est pas absorbant. Le miroir permet de réfléchir l'onde incidente avec un angle de façon à ce qu'elle soit absorbée par au moins un puits quantique. Un tel miroir a également été proposé pour l'amélioration du rendement de cellules solaires en couches minces de Si amorphe, dans le visible et proche infrarouge.

Dans tous les cas, un miroir métallique structuré permet de coupler par diffraction la radiation incidente à la couche absorbante de semi-conducteur.

Ainsi, le miroir métallique peut être structuré sous la forme d'un réseau bidimensionnel, notamment un réseau de plots dans des configurations diverses, par exemple plots carrés en réseau carré ou plots ronds en réseau carré ou hexagonal.

Les caractéristiques géométriques de ces réseaux ont fait l'objet d'optimisation, concernant l'efficacité du renforcement de l'absorption.

Ainsi, certaines références prévoient que la hauteur des plots ou des trous du miroir utilisé est de l'ordre d'un quart de la longueur d'onde d'utilisation, pour optimiser l'absorption des puits quantiques. On peut notamment citer le document WO 2005/081782 ou encore l'article de J.Y. Andersson et al, Appl. Phys. Lett. 59, 12 août 1991, 857.

Ceci conduit à un miroir d'épaisseur importante, lorsque le photodétecteur est utilisé dans l'infrarouge.

Ainsi, avec un matériau enrobant les structurations du réseau dont l'indice est de 2,5, les structurations présenteront une profondeur d'environ 400 nm pour une longueur d'onde de 4 $\mu$m. Ceci conduit à des miroirs d'épaisseur de l'ordre de 500 nm, l'épaisseur étant comptée entre le fond du miroir et le sommet des structurations.

Cette épaisseur importante peut poser un certain nombre de difficultés technologiques de réalisation.

Il est par exemple difficile de structurer de telles épaisseurs d'un matériau métallique en raison, par exemple, de problèmes de dépôt sur les flancs de résine dans les procédés dits de lift off, de remplissage de cavités profondes, ou de gravure de métaux nobles tels que l'or, mettant en oeuvre des procédés à base de plasma à hautes températures, typiquement des températures supérieures à 200° C.

Certaines références prévoient l'utilisation de structurations plus fines, avec des trous d'une profondeur de 200 nm pour une longueur d'onde de 10 $\mu$m, cette structuration permettant de renforcer l'absorption dans un détecteur à puits quantiques. C'est le cas de l'article de K.W. Goossen précédemment cité et de l'article de Cui Dafu et al, Infrared Phys. 32 (1991) 53.

Cependant, l'efficacité quantique de ces photodétecteurs, comme celle des photodétecteurs mentionnés précédemment, dépend considérablement de l'angle de la lumière incidente sur le photodétecteur. Ainsi, le spectre d'absorption de la couche de semi-conducteur présente dans le photodétecteur révèle un pic de résonance de l'absorption qui est fonction de l'angle de la lumière incidente. On constate qu'avec les miroirs connus, la position et la forme du pic d'absorption varient de manière importante avec l'angle d'incidence de l'onde sur le détecteur.

Ainsi, l'article de Cui Dafu et al, précédemment cité, montre une dépendance angulaire de l'efficacité quantique qui est très marquée : elle est de l'ordre de 0.1° dans le substrat et de 0.3° dans le milieu incident (air). Par ailleurs, l'article de Andersson et al, J. Appl. Phys. 171 (1992) 3600 tend à montrer une réponse angulaire très large avec une insensibilité jusqu'à au moins 15°. Cependant, c'est l'efficacité quantique intégrée sur la gamme spectrale de 8 à 12 $\mu$m qui est considérée, et non l'efficacité quantique à une longueur d'onde donnée en fonction de l'angle d'incidence. Or, cette dernière est plus difficile a obtenir. Elle est intéressante car elle permet d'envisager une détection hyperspectrale, c'est-à-dire la détection de plusieurs longueurs d'onde au sein d'une même gamme de détection (par exemple 4 « couleurs » différentes dans la même gamme 8-12 $\mu$m) sans que les couleurs se mélangent lorsque la radiation arrive selon un angle d'incidence.

On peut citer le document de brevet US 2009/0020701 qui décrit un photo-détecteur comprenant une couche de matériau super-conducteur de type NbN constituant une zone de photo-détection en forme de serpentin.

On peut également citer le document WO-2007054560 qui décrit une structure optique de localisation d'un champ électromagnétique, utilisée dans un photodétecteur pour obtenir une concentration du champ dans une zone active de détection. Ce photodétecteur peut notamment permettre de détecter un rayonnement infrarouge.

Cette structure comprend une couche, par exemple métallique, dont la surface présente deux zones de relief symétriques, séparées par une troisième zone.

Chaque zone de relief est obtenue par la répétition d'un motif élémentaire qui est une série de deux créneaux.

Ainsi, la troisième zone crée un défaut de périodicité de la structure optique.

La fonction de la structure optique est de coupler la lumière incidente à un mode guidé le long de la couche métallique et de localiser le champ électrique sous la couche métallique, au niveau de cette troisième zone. C'est là qu'est également localisée la zone de photodétection. Par contre, la zone périphérique entourant la zone de photodétection n'est pas le lieu d'une absorption optique.

La zone de photodétection n'est pas placée en champ proche du miroir structuré puisqu'elle est placée dans la zone de rupture de la périodicité de la structuration du miroir. Par ailleurs, la zone périphérique est placée en champ proche du miroir mais ne participe pas à la photodétection.

Enfin, la zone de photodétection est limitée, puisqu'elle ne correspond qu'à une faible partie de la structure de localisation.

La limitation de la zone de détection impose des contraintes technologiques qui compliquent la fabrication du photodétecteur.

L'invention a pour objet de pallier les inconvénients des photodétecteurs de l'état de la technique en proposant un photodétecteur comprenant une couche mince de semi-conducteur et un miroir métallique structuré et qui augmente l'efficacité quantique d'absorption de cette radiation lumineuse, mesurée par exemple comme le rapport entre la puissance lumineuse absorbée dans le semi-conducteur et la puissance lumineuse incidente.

Il présente de plus une largeur spectrale importante.

Ainsi, l'invention concerne un photodétecteur pour une radiation lumineuse de longueur d'onde donnée $\lambda$ comprenant un empilement de couches avec :

- une couche continue d'un matériau semi-conducteur partiellement absorbant, constituant la zone de photodétection,
- une couche d'espacement en un matériau transparent à ladite longueur d'onde et d'indice ne, et
- un miroir métallique structuré, la distance g entre le sommet dudit miroir et la couche de semi-conducteur étant inférieure à $\lambda$/ne et la surface du miroir présentant un profil correspondant à la répétition périodique, selon la période P, d'un motif élémentaire, défini par la succession alternée de reliefs et de fentes, respectivement de largeur $L_1$, $L_2$ et $L_3$, $L_4$, les largeurs $L_1$ à $L_4$ étant telles qu'aucune n'est nulle, leur somme est égale à P et au moins $L_1 \neq L_2$ ou $L_3 \neq L_4$.

Ce photodétecteur présente également une sensibilité réduite à l'angle d'incidence de la radiation lumineuse infrarouge utilisée et une acceptance angulaire bien définie.

Enfin, aucune structuration de la couche de semi-conducteur n'est nécessaire.

De façon préférée, l'épaisseur e de la couche de matériau semi-conducteur satisfait à la relation

$$e \leq 0,7 \times \frac{\lambda}{4 \times \pi \times kSC} ,$$ où kSC est la partie imaginaire de l'indice de réfraction dudit matériau semi-conducteur.

De façon préférée, la profondeur h des fentes est comprise entre $\lambda$/12nc et $\lambda$/5nc où nc est la partie réelle de l'indice du matériau présent dans les fentes.

Selon une variante, le photodétecteur comprend, sur la couche de matériau semi-conducteur, un substrat transparent à ladite longueur d'onde et d'indice de réfraction ns.

Ce substrat pourra par exemple être le substrat de croissance de la couche de semi-conducteur absorbante, par exemple un substrat de CdZnTe dans le cas où l'on veut faire croître une couche de CdHgTe. Le substrat pourra aussi contribuer à la cohésion mécanique du photodétecteur final.

De façon préférée, la période P est égale à $\lambda$/neff où neff est compris entre min (ns, ne, nSC) et max (ns, ne, nSC) où nSC est la partie réelle de l'indice de réfraction dudit matériau semi-conducteur.

Selon une variante, la largeur $L_1$, $L_2$ d'un des reliefs est comprise entre $P/2-L_3$ et $2P/3-L_3$ et la largeur $L_3$, $L_4$ des fentes est comprise entre $\lambda/15.ne$ et $\lambda/5.ne$.

De façon préférée, g est comprise entre $\lambda/15ne$ et $\lambda/3ne$.

Selon une autre variante, l'indice ne est supérieur à $nSC/2$.

Dans une première variante, le réseau dudit miroir présente un faisceau de lignes en creux.

Dans une autre variante, ce réseau présente deux faisceaux croisés de lignes en creux parallèles. Elles peuvent également être parallèles ou non aux bords du photodétecteur.

Le choix entre une configuration en une dimension ou en deux dimensions permet de rendre le photodétecteur sensible à ou indépendant de la polarisation de la lumière incidente.

De façon préférée, le matériau semi-conducteur est choisi parmi Si, Ge, SiGe, InAs, InSb, GaSb, PbS, PbSe, PbTe ou $Cd_xHg_{1-x}Te$ (avec x<0,9), des alliages ternaires comme InGaAs, AlInAs, AlInSb, InAsSb ou InGaSb, des alliages quaternaires comme InGaAsP ou InGaAsSb et des alliages quinaires comme GaInAsSb ou GaInAsSbP, ou encore un superréseau de type II, par exemple InAs/InSb sur GaSb.

Par ailleurs, le matériau de la couche d'espacement est choisi parmi ZnS, CdTe ou des matériaux III-V.

L'invention sera mieux comprise et d'autres buts, avantages et caractéristiques de celle-ci apparaîtront plus clairement à la lecture de la description qui suit et qui est faite au regard des dessins annexés, sur lesquels :

- la figure 1 est une vue en coupe d'un exemple de photodétecteur selon l'invention,
- la figure 2 présente deux courbes $C_1$ et $C_2$ montrant, pour un photodétecteur selon l'invention (⎯⎯⎯), et pour un photodétecteur comportant un miroir non structuré (⎯ ⎯), l'efficacité quantique du photodétecteur en fonction de la longueur d'onde et pour une lumière incidente perpendiculaire au photodétecteur,
- la figure 3 présente un réseau de cinq courbes $C'_1$ à $C'_5$ montrant l'efficacité quantique d'un photodétecteur selon l'invention en fonction de la longueur d'onde et pour une lumière incidente perpendiculaire au photodétecteur, à différents angles d'incidence,
- la figure 4 présente trois courbes, la première $Q_1$ (⎯⎯⎯) représentant l'efficacité quantique maximale d'un photodétecteur selon l'invention, la deuxième $Q_2$ (- -) la valeur moyenne de deux valeurs de l'efficacité quantique de ce même photodétecteur prises autour du pic de résonance et la troisième $Q_3$ (· · · ·) la valeur moyenne de l'efficacité quantique d'un photodétecteur dont le miroir ne comporte pas de structuration, ces courbes étant fonction du paramètre g et données pour une lumière incidente perpendiculaire au photodétecteur,

- la figure 5 présente cinq courbes $G_1$ à $G_5$ représentant l'efficacité quantique maximale d'un photodétecteur selon l'invention, en fonction de l'angle d'incidence, pour cinq valeurs du paramètre g,
- la figure 6 présente trois courbes $G'_1$, $G'_2$ et $G'_4$ illustrant la position spectrale du maximum de l'absorption en fonction de l'angle d'incidence et pour trois valeurs du paramètre g,
- la figure 7 présente un réseau de quatre courbes $T_1$ à $T_4$ montrant, en fonction de la longueur d'onde et pour différents indices du substrat transparent, l'efficacité quantique d'un photodétecteur selon l'invention,
- la figure 8 est une vue partielle de dessus d'un miroir présentant une structuration en deux dimensions,
- la figure 9 présente deux courbes $R_1$ et $R_2$ montrant l'efficacité quantique de deux photodétecteurs de même dimensionnement en fonction de la longueur d'onde, l'un présentant un miroir dont la structuration est en une dimension et l'autre un miroir dont la structuration est en deux dimensions,
- la figure 10 représente un réseau de courbes $K_1$ à $K_5$ similaire à celui de la figure 3, pour un photodétecteur selon l'état de la technique et
- la figure 11 représente un réseau de courbes $H_1$ à $H_5$ similaire à celui de la figure 3, pour un photodétecteur dont le miroir comporte une structure avec des reliefs et des fentes de même largeur et des caractéristiques particulières.

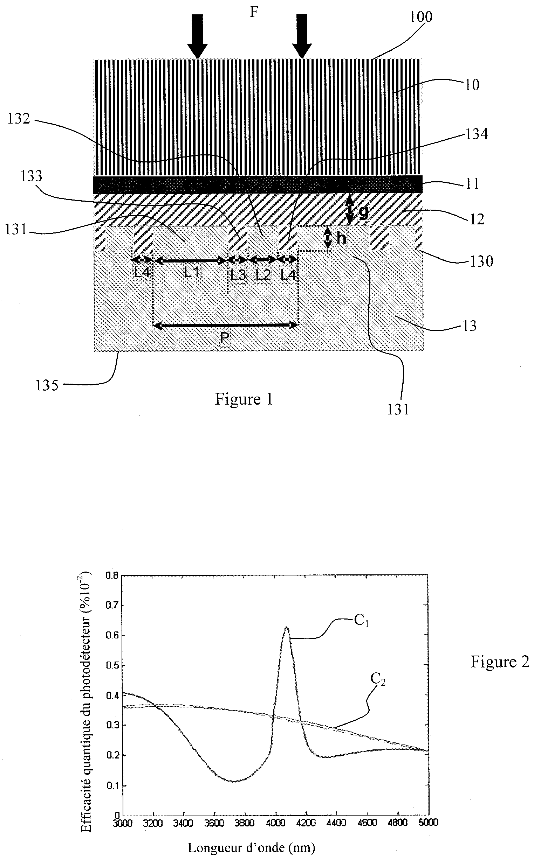

La figure 1 illustre un exemple d'un photodétecteur 1 selon l'invention.

Ce photodétecteur comporte un empilement de couches, illustré en coupe sur la figure 1 avec tout d'abord un substrat 10 qui est transparent à la longueur d'onde $\lambda$ de la radiation lumineuse utilisée.

La longueur d'onde $\lambda$ est supérieure à environ 1 $\mu$m et peut aller jusqu'à l'infrarouge lointain. Elle est typiquement de l'ordre de 30 $\mu$m.

Les flèches F illustrent la propagation de la radiation lumineuse incidente au niveau de la face avant 100 du photodétecteur.

La radiation lumineuse se propage à l'intérieur du substrat 10, en subissant un phénomène de réfraction au passage de l'interface air-substrat, induisant une modification de son angle d'incidence selon la loi de Snell-Descartes. Le substrat étant d'indice supérieur à celui de l'air, l'angle d'incidence dans le substrat sera plus faible que l'angle d'incidence dans l'air. Ce substrat jouera le rôle de substrat de croissance du semi-conducteur, ou bien d'élément assurant la cohésion mécanique du photodétecteur.

Ce substrat transparent peut être réalisé en CdZnTe.

En contact avec le substrat transparent 10, est prévue une couche 11 d'un matériau semi-conducteur.

Cette couche 11 est continue et elle constituera la zone de photodétection du photodétecteur.

L'indice optique du matériau semi-conducteur se décompose en une partie réelle nSC et une partie imaginaire kSC.

Ce substrat transparent peut être omis dans d'autres modes de réalisation du photodétecteur selon l'invention.

La couche 11 de semi-conducteur est alors en contact avec l'air.

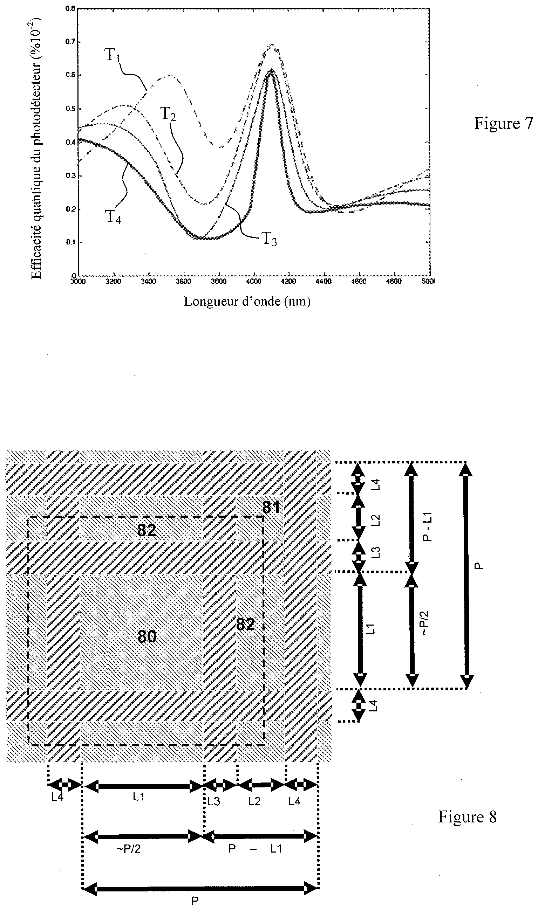

Il sera montré au regard de la figure 7 que, dans ce cas, l'efficacité quantique maximale du photodétecteur selon l'invention est plus importante qu'avec des substrats présentant un indice plus élevé.

En pratique, le matériau constitutif du substrat transparent 10 présente donc un indice optique ns qui est compris entre 1, valeur de l'indice de l'air, et nSC qui est la partie réelle de l'indice optique du matériau constitutif de la couche de semi-conducteur.

Le fait que la couche de semi-conducteur soit à nu diminue la durée de vie du dispositif photodétecteur, ou bien encore induit une forte recombinaison des porteurs photogénérés à la surface de cette couche et donc une diminution de rendement de collection des charges photogénérées.

Pour pallier ce problème, une couche de passivation électrique pourra alors être prévue sur la couche 11. Cette couche devra être suffisamment fine pour ne pas influer sur les caractéristiques optiques du dispositif (typiquement on la choisira petite devant la longueur d'onde). Il peut, par exemple, s'agir d'une couche de Cd-Te recouverte d'une couche de ZnS, toutes deux présentant une épaisseur d'environ 100 nm.

Le matériau semi-conducteur ainsi que son épaisseur sont choisis pour qu'il soit partiellement absorbant.

L'épaisseur e de cette couche de matériau semi-conducteur est choisie de telle sorte que la couche 11 de semi-conducteur n'est pas totalement absorbante. Elle pourra avantageusement répondre à la relation (1) suivante :

$$e \leq 0,7 \times \frac{\lambda}{4 \times \pi \times kSC} \quad (1)$$

où kSC est la partie imaginaire de l'indice de réfraction du matériau semi-conducteur.

Ce matériau pourra être choisi parmi les matériaux suivants : Si, Ge, SiGe, InAs, InSb, GaSb, PbS, PbSe, PbTe ou $Hg_xCd_{1-x}Te$ (avec x<0,9), des alliages ternaires comme InGaAs, AlInAs, AlInSb, InAsSb ou In-GaSb, des alliages quaternaires comme InGaAsP ou In-GaAsSb et des alliages quinaires comme GaInAsSb ou GaInAsSbP, ou encore un superréseau de type II, par exemple InAs/InSb sur GaSb.

Il convient de noter que le type de dopage et sa concentration sont indifférents dans le cadre de l'invention. En effet, l'aspect photonique de génération des porteurs est indépendant de la collection de ces porteurs. On pourra donc utiliser tout système de collection classique de l'art antérieur.

Une jonction pn sera réalisée par deux prises de contact dans la couche de semi-conducteur. Une zone dopée n est réalisée près d'un contact et les porteurs photogénérés dans la zone p diffusent alors vers la jonction ainsi formée et sont collectés.

Le niveau de dopage nécessaire à la formation de cette jonction pn est assez faible, typiquement de l'ordre de $10^{17}$ à $10^{19}/cm^3$. En conséquence, il ne modifiera pas les propriétés d'absorption optique du photodétecteur.

L'empilement comporte encore un miroir métallique 13 et, entre la couche de semi-conducteur 11 et le miroir 13, une couche d'espacement 12.

Dans l'exemple illustré sur la figure 1, le miroir comporte, sur sa surface 130, en contact avec la couche d'espacement 12, une série de reliefs qui seront décrits ultérieurement.

Cette couche d'espacement 12 est réalisée dans un matériau transparent à la longueur d'onde de la radiation lumineuse utilisée et qui présente un indice ne.

Ce matériau peut être du ZnS, du CdTe ou des matériaux III-V suivant le groupe auquel appartient le semi-conducteur absorbant. On peut également envisager du SiN, si le matériau semi-conducteur utilisé est du Ge ou du SiGe.

L'indice ne du matériau constitutif de cette couche d'espacement est avantageusement choisi supérieur à nSC/2, de manière à assurer un bon fonctionnement du photodétecteur.

Cette couche d'espacement 12 pourra remplir la fonction d'une couche de passivation électrique pour la couche de semi-conducteur 11, dans laquelle sont photogénérés les porteurs électriques, notamment lorsque la couche 11 est réalisée en HgCdTe. Ceci permet d'éviter tout contact électrique avec le miroir, pour assurer une collection efficace des électrons photogénérés.

Elle pourra également remplir la fonction de barrière de diffusion, par exemple pour éviter que le métal constituant le miroir 13 ne diffuse dans la couche de semi-conducteur 11.

Ainsi, l'épaisseur minimale de la couche 12 sera d'environ 50 nm.

Il convient de noter que la fonction de cette couche d'espacement est donc différente de celle de la couche d'espacement décrite dans l'article de K.W. Goossen et al, mentionné plus haut.

En effet, cette dernière est réalisée en un matériau semi-conducteur dopé et elle remplit une fonction de contact électrique.

On va maintenant s'intéresser à la structuration du miroir 13, sur sa surface 130.

La surface 130 présente un profil qui correspond à la répétition périodique d'un motif élémentaire, selon la période P.

Le motif élémentaire a une longueur égale à la période P.

Il est défini par quatre paramètres $L_1$ à $L_4$ selon un axe de la surface 130 et un paramètre h selon un axe perpendiculaire.

$L_1$ et $L_2$ correspondent à la largeur des reliefs 131 et 132 et $L_3$ et $L_4$ correspondent à la largeur des portions de la surface 130 situées entre les reliefs. Ainsi, la portion 133 de largeur $L_3$ est située entre les reliefs 131 et 132 d'un même motif et la portion 134 de largeur $L_4$ est située entre le relief 132 d'un motif et le relief 131 du motif adjacent. Les portions 133 et 134 seront dénommées des fentes.

Dans l'exemple illustré à la figure 1, les reliefs sont sensiblement de la même hauteur h.

Chacun des paramètres $L_1$ à $L_4$ est non nul et leur somme est égale à P.

Enfin, ils vérifient la condition selon laquelle au moins $L_1 \neq L_2$ ou $L_3 \neq L_4$.

Le miroir 13 doit être placé en champ proche de la fine couche de semi-conducteur 11, pour permettre le renforcement de l'absorption de cette couche 11.

Pour cela, la distance g entre le sommet du miroir 13 et la couche de semi-conducteur 11 doit être inférieure à $\lambda$/ne où ne est l'indice de la couche d'espacement 12. Le sommet du miroir est défini par la face supérieure des reliefs 131 et 132.

Elle sera typiquement comprise entre $\lambda$/15ne et $\lambda$/3ne. Dans cette gamme de valeurs, on peut obtenir une amélioration de la réjection tout en conservant une insensibilité angulaire et une largeur spectrale importantes.

Ceci sera détaillé dans la suite de la description.

La structuration du miroir 13 permet de coupler la lumière incidente à un mode guidé parallèle à la couche 11 de semi-conducteur avec un champ électrique évanescent qui est maximal au sommet du miroir et qui décroit vers le substrat 10. Dans une configuration dite de champ proche, la couche absorbante 11 est placée suffisamment proche du miroir pour être dans cette région de renforcement du champ électromagnétique. Ceci correspond à une distance g inférieure à $\lambda$/ne de la surface du miroir.

Le positionnement de la couche absorbante en champ proche avec le miroir structuré permet d'élargir la réponse spectrale et d'améliorer l'insensibilité angulaire du photodétecteur en fonction de l'angle de la lumière incidente.

La structuration du miroir peut être réalisée en une ou deux dimension(s).

Dans le cas d'une structuration en une dimension, les reliefs 131 et 132 s'étendent, sur la surface 130, selon des lignes sensiblement parallèles. En d'autres termes, le réseau du miroir est défini par un faisceau de lignes en creux ou en relief.

Pour un miroir de ce type, la résonance de l'absorption sera donc générée uniquement en polarisation TM, c'est-à-dire pour un champ magnétique de la radiation lumineuse incidente parallèle aux lignes du réseau.

La structuration peut également être prévue en deux dimensions, comme cela sera décrit en référence à la figure 8.

Les matériaux pouvant être utilisés pour réaliser le miroir 13 sont les métaux nobles tels que l'or, l'aluminium et le cuivre ainsi que tous les métaux dans la mesure où leur conductivité n'est pas plus de vingt fois inférieure à celle de l'or.

Les structurations pourront inclure une couche mince de métal servant à assurer l'accroche du métal précédent sur la couche d'espacement 12, par exemple du titane Ti.

La période P de la structuration permet d'ajuster la longueur d'onde de résonance $\lambda_{rs}$, suivant la relation (2) : $\lambda_{rs}$=neff.P,
où neff est un indice effectif qui est compris entre min (ns, ne, nSC) et max (ns, ne, nSC).

La largeur $L_3$ ou $L_4$ des fentes 133 ou 134 du profil de la surface 130 sera choisie entre $\lambda$/15.ne et $\lambda$/5.ne.

La valeur de $L_3$ ou $L_4$ dans cette gamme dépend faiblement de la hauteur h des reliefs et pourra être optimisée.

La largeur $L_1$ d'un des reliefs du motif sera comprise entre $P/2-L_3$ et $2P/3-L_3$.

La largeur $L_2$ de l'autre relief du motif sera donc donnée par la relation $L_2 = P - (L_1 + L_3 + L_4)$.

La figure 1 illustre une largeur $L_1$ supérieure à $L_2$. Cependant, ceci ne présente aucun caractère limitatif. Les largeurs $L_1$ et $L_2$ sont en effet interchangeables du fait de la répétition d'un même motif sur la surface 130 du miroir.

Enfin, la profondeur de la structuration du miroir, c'est-à-dire la hauteur h des reliefs 131 ou 132 ou encore la profondeur des fentes 133 ou 134, sera comprise entre $\lambda$/12.ne et $\lambda$/5.ne et elle sera choisie typiquement sensiblement égale à $\lambda$/7.ne.

Si le matériau qui remplit les fentes 133 et 134 est différent de celui présent entre le sommet du miroir 13 et la couche 11 de semi-conducteur, h sera comprise entre $\lambda$/5.nc et $\lambda$/12.nc, où nc est la partie réelle de l'indice de ce matériau.

En pratique, la procédure pour déterminer les paramètres du réseau, à partir d'un empilement vertical donné dans lequel sont définis les matériaux constitutifs, l'épaisseur de la couche de semi-conducteur et le paramètre g, est la suivante ($L_3$ est ici égale à $L_4$) :

Tout d'abord, en utilisant une méthode de simulation (par exemple du type FDTD ou FEM), il convient de simuler la réponse d'un photodétecteur comportant une seule fente à une lumière incidente polarisée TM.

Le champ électrique doit être calculé en fonction de la longueur d'onde de la lumière incidente à un point proche de l'embouchure de la fente.

Pour une valeur de la largeur de la fente $L_3$ dans la gamme définie ci-dessus, il convient de trouver la valeur de h correspondant à un pic d'intensité de champ électrique à la longueur d'onde souhaitée.

Ensuite, en fixant P = $\lambda$/ns, un réseau peut se construire. La simulation sera donc réalisée sur la base d'un motif répété.

Les valeurs spécifiques de $L_1$, $L_2$ et $L_3$ sont choisies parmi les gammes définies ci-dessus, suivant une optimisation maximisant l'absorption maximale et/ou la stabilité angulaire. Cette étape est réalisée en utilisant une méthode de simulation avec conditions aux limites périodiques.

Une fois que les paramètres $L_1$ et $L_3$ sont optimisés, le pic de l'absorption est généralement légèrement décalé vers le rouge, par rapport à $\lambda$ = ne . P. Pour obtenir un pic à la longueur d'onde souhaitée, $P_1$ et $L_1$ peuvent être réduites proportionnellement, afin d'obtenir la correction souhaitée.

Il convient de noter que la hauteur h est relativement faible par rapport à la longueur d'onde incidente dans la couche d'espacement 12. Ceci facilite la réalisation technologique du miroir 13.

Ainsi, à titre de comparaison, les miroirs décrits dans l'article de J.Y. Andersson et al. mentionné plus haut, présentent une hauteur de structuration h de l'ordre de $\lambda$/4nc, nc étant généralement égal à ne.

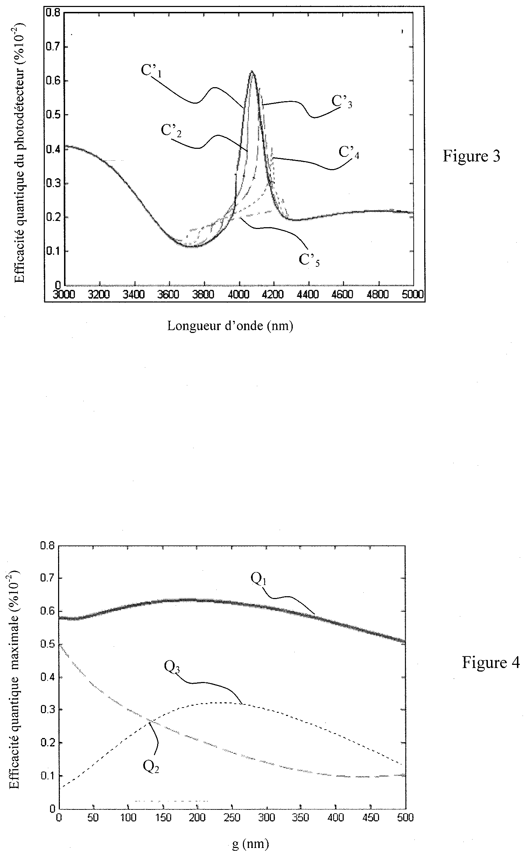

Par ailleurs, dans la gamme de hauteurs h mentionnée plus haut, qui est relativement restreinte, le photodétecteur présente une sensibilité angulaire réduite, comme cela sera illustré en référence à la figure 3.

Un exemple particulier de réalisation d'un photodétecteur tel qu'illustré à la figure 1 va maintenant être décrit.

L'influence des différents paramètres mentionnés ci-dessus va être mise en évidence avec cet exemple particulier, comportant un miroir structuré en une dimension.

Ainsi, le photodétecteur considéré comporte une couche de substrat transparent et une couche d'espacement en CdTe, dont l'indice optique est de 2,68, et une couche de semi-conducteur du type tellurure cadmium mercure (MCT), de formule générale $Hg_xCd_{1-x}Te$, avec x=0.3 à une température de 77°K.

La longueur d'onde $\lambda$ de la radiation lumineuse incidente est comprise entre 3 et 5 $\mu$m.

Par ailleurs, la partie imaginaire kSC de l'indice de réfraction du matériau semi-conducteur est de l'ordre de 0.26 pour une longueur d'onde de 4 $\mu$m. Ainsi, la relation (1) conduit à une épaisseur de la couche de semi-conducteur inférieure à environ 850 nm, pour cette longueur d'onde.

Dans cet exemple particulier, l'épaisseur de la couche de semi-conducteur sera choisie égale à 100 nm.

Le miroir métallique est réalisé en or et la distance g entre le sommet du miroir métallique et la couche de semi-conducteur 11 est égale à 250 nm. Elle est donc inférieure à $\lambda$/ne, pour la gamme de longueur d'onde retenue. Elle est également comprise dans la gamme préférée située entre $\lambda$/15ne et $\lambda$/3ne.

Par ailleurs, l'épaisseur entre la surface 130, correspondant au fond des fentes, et le fond du miroir, correspondant à la surface 135 opposée à la surface 130, est au moins égale à l'épaisseur de peau à la longueur d'onde considérée. Cette dernière sera de l'ordre de 25 nm pour un miroir en or à une longueur d'onde de 4 $\mu$m.

La période P du réseau est choisie égale à 1 490 nm, ce qui correspond environ à $\lambda$/ne, ne étant bien comprise dans la gamme min (ne, ns, nSC) et max (ne, ns, nSC).

Les largeurs $L_3$ et $L_4$ des fentes 133 et 134 sont ici égales. Elles sont choisies égales à 125 nm. Cette valeur est bien comprise dans la gamme retenue située entre $\lambda$/15.ne et $\lambda$/5. ne (100-300 nm pour $\lambda$ = 4 $\mu$m).

La largeur $L_1$ d'un des reliefs du motif sera choisie égale à 740 nm. Cette valeur correspond sensiblement à P/2 et elle est bien comprise dans la gamme mentionnée précédemment.

La largeur $L_2$ de l'autre des reliefs du motif est donc égale à 500 nm, compte tenu des valeurs choisies pour P, $L_1$, $L_3$ et $L_4$.

Enfin, la profondeur de la structuration du miroir, c'est-à-dire la hauteur h, est de 220 nm, ce qui correspond à environ $\lambda$/7ns. Cette valeur de h a été mentionnée précédemment, étant entendu que, dans cet exemple, les valeurs des indices ns et ne sont égales.

La figure 2 illustre avec la courbe $C_1$ en traits pleins et pour cet exemple de photodétecteur, son efficacité quantique (c'est-à-dire le rapport entre la puissance absorbée et la puissance incidente ou encore le rapport entre le nombre de paires électron-trou effectivement générées par absorption dans la couche de semi-conducteur et le nombre de photons incidents) en fonction de la longueur d'onde (exprimée en nm), pour une lumière incidente perpendiculaire au photodétecteur de polarisation TM et pour une température de fonctionnement de 77 K.

Cette couche d'absorption fait apparaître un pic de résonance, fonction de l'angle d'incidence et de la longueur d'onde de résonance, qui est ici d'environ 4 080 nm.

Cette courbe montre que l'absorption optique dans la couche de semi-conducteur est d'environ 63 % de la puissance incidente pour la longueur d'onde de résonance.

En l'absence de structuration du miroir, cette absorption serait comprise seulement entre 20 et 40 % de la puissance incidente.

C'est ce qu'illustre la courbe $C_2$ qui donne l'efficacité quantique d'un photodétecteur comportant un miroir sans structuration, ce dernier comportant par ailleurs la même structure que le photodétecteur selon l'invention ainsi que les mêmes matériaux constitutifs.

Il convient également de noter que la courbe $C_2$ correspond sensiblement à celle de l'efficacité quantique de l'exemple de photodétecteur selon l'invention précédemment décrit, en polarisation TE.

La similarité entre ces deux courbes montre que la lumière polarisée en TE ne voit pas la structuration du miroir et donc la réponse du photodétecteur selon l'invention est identique à la réponse en TM pour un photodétecteur comportant un miroir sans structuration. Ceci montre la sensibilité de la réponse du photodétecteur selon l'invention à la polarisation de la lumière incidente.

Enfin, la courbe $C_1$ montre que le photodétecteur selon l'invention permet de diminuer l'absorption de fond pour les longueurs d'onde situées autour de la longueur d'onde de résonance.

Cette notion d'absorption de fond fait référence à la réponse du photodétecteur, dans toute la gamme spectrale, en dehors du ou des pics de résonance, c'est-à-dire des pics qui sont dus à la structuration du miroir.

Ainsi, pour la courbe $C_1$, l'absorption de fond est l'absorption pour des longueurs d'onde inférieures à 4 $\mu$m ou supérieures à 4,2 $\mu$m, dans la mesure où la résonance est d'environ 4,1 $\mu$m, et où cette courbe ne présente qu'un pic de résonance.

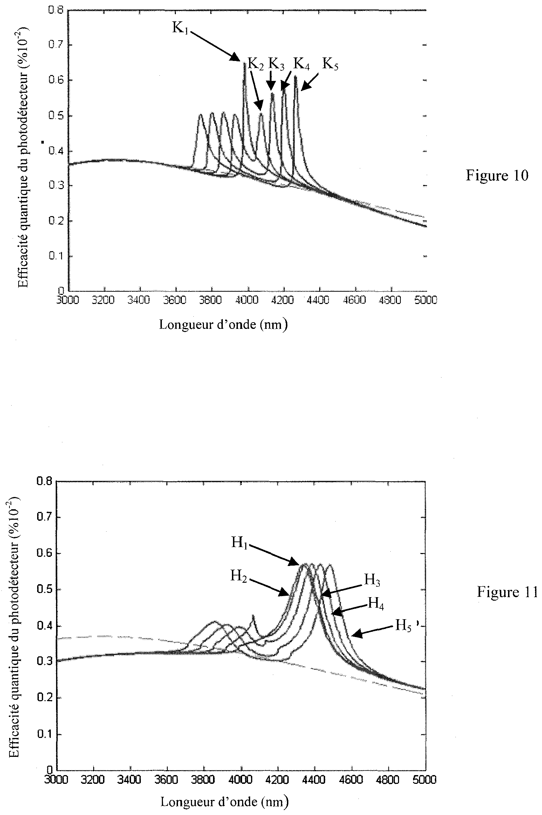

La figure 2 montre que, pour la courbe $C_1$, cette absorption de fond est faible. En conséquence, la réjection spectrale est importante, la réjection étant définie comme le rapport entre l'efficacité quantique maximale et l'absorption de fond. Ceci apparaîtra plus clairement au regard des figures 10 et 11 qui illustrent des courbes d'absorption pour des photodétecteurs dont le miroir comporte une structuration avec des reliefs, respectivement des fentes de même largeur.

Il convient de noter que la valeur de la période P et celle de la largeur $L_1$ d'un des reliefs permettent de régler la valeur de la longueur d'onde de résonance, les valeurs de h, g, $L_3$ et $L_4$ étant par ailleurs égales. Ainsi, avec l'exemple de photodétecteur décrit plus haut, une variation de P comprise entre 1 190 nm et 1 790 nm et une variation de $L_1$ comprise entre 595 et 895 nm permettent de faire varier la longueur d'onde de résonance entre 3,24 et 4,86 $\mu$m.

Les résultats détaillés sont rassemblés dans le tableau ci-dessous.

| P | L1 | L2 | $\lambda_{max}$ | QE$_{max}$ |
|---|---|---|---|---|
| 1190 | 595 | 345 | 3240 | 0.64 |
| 1290 | 645 | 395 | 3540 | 0.62 |
| 1390 | 695 | 445 | 3820 | 0.62 |
| 1490 | 745 | 495 | 4080 | 0.63 |
| 1590 | 795 | 545 | 4340 | 0.61 |
| 1690 | 845 | 595 | 4600 | 0.55 |
| 1790 | 895 | 645 | 4860 | 0.40 |

En pratique, la longueur d'onde de résonance est ajustée grâce aux paramètres géométriques de la structure, tels que la nature et les épaisseurs des matériaux mis en contact avec la couche de semi-conducteur, le métal constituant le miroir structuré, l'épaisseur de la couche de semi-conducteur ou la valeur de g. Cependant, les variations de ces paramètres sont du deuxième ordre sur l'ajustement de la longueur d'onde de résonance, par rapport au choix de P et de $L_1$.

Il est maintenant fait référence à la figure 3 qui illustre un réseau de courbes similaires à celle de la figure 2 et correspondant à des angles d'incidence variant entre 0 et 4°. Ces courbes ont été obtenues avec un photodétecteur selon l'invention, identique à l'exemple décrit ci-dessus.

Ainsi, la courbe $C'_1$ en trait plein correspond à la courbe $C_1$ illustrée à la figure 2. La radiation lumineuse est donc perpendiculaire à la surface du photodétecteur.

La courbe $C'_2$ correspond également à une courbe montrant l'efficacité quantique du photodétecteur en fonction de la longueur d'onde, mais pour une lumière incidente sur la couche 11 faisant un angle de 1° par rapport à la normale.

De même, la courbe $C'_3$ correspond à une variation de l'angle d'incidence de 2°, la courbe $C'_4$ à une variation de 3° et la courbe $C'_5$ à une variation de 4°.

Ce faisceau de courbes montre que l'efficacité quantique du photodétecteur ne varie pas en fonction de l'angle d'incidence, si cette variation est de $\pm$ 2° dans le substrat transparent 10, ce qui correspond à une variation de $\pm$ 5,4° dans l'air.

En effet, pour un angle d'incidence de 2° (courbe $C'_3$), la valeur de l'efficacité quantique au niveau du pic de résonance représente environ 95% de la valeur correspondante pour un angle d'incidence nul (courbe $C'_1$). De plus, pour cette courbe $C'_3$, la longueur d'onde de résonance n'est que légèrement décalée par rapport à la longueur d'onde de résonance correspondant à la courbe $C'_1$. En effet, ce décalage est d'environ 1%.

Par contre, lorsque l'angle d'incidence devient supérieur à 2°, la valeur de l'efficacité quantique au niveau du pic de résonance diminue rapidement.

Ceci montre à la fois que le photodétecteur selon l'invention est pratiquement insensible angulairement dans une gamme d'angle d'environ $\pm$ 2° et que ce photodétecteur présente une acceptance angulaire bien définie correspondant à cette gamme. En d'autres termes, le photodétecteur voit bien la même couleur dans cette gamme.

Des essais ont été réalisés pour étudier l'influence du paramètre h. Tous les autres paramètres étant par ailleurs égaux, la valeur de h a été modifiée et des courbes similaires à celles de la figure 3 ont été obtenues.

Ces essais montrent que, lorsque la hauteur h des reliefs est inférieure à la gamme précédemment définie (par exemple égale à 120 ou 170 nm), l'efficacité quantique est faible même pour une lumière perpendiculaire au photodétecteur. Par ailleurs, lorsque la hauteur h est supérieure à cette gamme (par exemple égale à 320 nm), la sensibilité angulaire augmente et la propriété d'acceptance angulaire est perdue. De plus, pour des valeurs de h plus élevées (par exemple h égale à 420 nm), l'efficacité quantique redevient faible.

Enfin, la figure 3 montre également que, pour des angles d'incidence supérieure à 2°, le photodétecteur selon l'invention permet de quasiment supprimer les pics parasites décalés en longueur d'onde, par rapport à la longueur d'onde de résonance. Lorsque la courbe représentant l'efficacité quantique du photodétecteur en fonction de la longueur d'onde comporte des pics parasites, le photodétecteur donne une réponse pour des longueurs d'onde différentes suivant l'angle d'incidence. Il est donc intéressant de les supprimer lorsque l'on souhaite faire une image d'une longueur d'onde donnée quel que soit l'angle de vue. C'est notamment le cas pour des applications en imagerie hyperspectrale ou en spectroimagerie.

La suppression des pics parasites pour un photodétecteur selon l'invention apparaît clairement de la comparaison avec les figures 10 et 11.

Ainsi, la figure 10 illustre un réseau de courbes similaire à celui de la figure 3, pour un photodétecteur du type décrit dans les articles de K.W. Goossen et al et Cui Dafu et al mentionnés plus haut. Ce photodétecteur comporte donc un miroir structuré selon un motif périodique, ce motif ne comportant qu'une fente et donc un seul relief.

A l'exception du miroir, ce photodétecteur est constitué du même empilement que l'exemple de photodétecteur décrit plus haut, cet empilement étant réalisé dans les mêmes matériaux. Ainsi, il comprend une couche de semi-conducteur du type $Hg_xCd_{1-x}Te$ dont l'épaisseur est de 100 nm.

La période de la structuration du miroir est choisie égale à 1 490 nm, la largeur du relief est de 1 190 nm et la largeur de la fente de 300 nm.

Enfin, la hauteur h de la structuration du miroir est choisie égale à 525 nm.

Chacune des courbes $K_1$ à $K_5$ donne l'efficacité quantique du photodétecteur en fonction de la longueur d'onde, et pour un ange d'incidence allant de 0° (courbe $K_1$) à 4° (courbe $K_5$).

La figure 10 montre que pour une lumière incidente perpendiculaire au photodétecteur (courbe $K_1$), le pic de résonance correspond à une efficacité quantique d'environ 65%. Cependant, dès que l'angle d'incidence augmente, la courbe comporte deux pics et plus un seul, les deux pics se décalant rapidement et symétriquement en fonction de l'angle d'incidence.

On constate que la réponse de ce photodétecteur varie considérablement dès que la lumière incidence n'est pas perpendiculaire au photodétecteur. Sa sensibilité angulaire est donc très importante.

De plus, l'intensité des deux pics ne diminue pas lorsque l'angle d'incidence augmente. Ainsi, il n'est pas possible de déterminer avec exactitude quelle est la couleur observée, celle-ci étant définie par la longueur d'onde de résonance. L'incertitude sur la couleur est d'autant plus grande que les angles d'incidence sont importants. Ceci entraîne une perte en résolution spectrale pour les applications en spectroscopie.

La figure 11 montre également un faisceau de courbes similaires à celui illustré aux figures 3 et 10, pour un photodétecteur comportant une structure similaire à l'exemple de photodétecteur selon l'invention précédemment décrit, mais dont le miroir est différent. En effet, ce miroir est structuré selon la répétition périodique d'un motif comportant seulement un relief et une fente.

Par ailleurs, la période P est choisie comprise entre 0,5 λ/nSC et 1,5 λ/nSC, où nSC est la partie réelle de l'indice de réfraction du matériau semi-conducteur, la largeur L de relief étant comprise entre 9P/10 et P/2 et la profondeur h de la fente étant comprise entre λ/100 et λ/15.

Le photodétecteur choisi ici présente une période P égale à 1 490 nm, la largeur L du relief est de 1 190 nm et la hauteur h du relief de 125 nm, pour λ = 4300 nm.

En conséquence, la largeur de la fente est de 300 nm.

La figure 11 comporte elle aussi cinq courbes $H_1$ à $H_5$ qui donnent l'efficacité quantique du photodétecteur en fonction de la longueur d'onde pour des angles d'incidence de la lumière compris entre 0 et 4°.

La figure 11 montre que, pour une lumière perpendiculaire au photodétecteur (courbe $H_1$), la réponse du photodétecteur ne comporte qu'un pic à la longueur de résonance.

Cependant, dès que l'angle d'incidence n'est plus nul (courbes $H_2$ à $H_5$), la réponse du photodétecteur comporte non seulement un pic à la longueur d'onde de résonance mais également un pic secondaire d'absorption.

Par ailleurs, la hauteur du pic principal de résonnance reste approximativement stable, lorsque l'angle d'incidence augmente. Cependant, la longueur d'onde de résonnance se décale avec l'augmentation de cet angle.

Ainsi, le photodétecteur selon l'invention présente l'avantage, par rapport au photodétecteur correspondant à la figure 11, de supprimer le décalage du pic principal de résonnance avec l'angle d'incidence ainsi que les pics secondaires de résonnance pour un angle d'incidence supérieur à 2°. Un autre avantage est la suppression de l'absorption de fond autour du pic principal et donc l'obtention d'une meilleure réjection.

Il est maintenant fait référence à la figure 4.

La courbe $Q_1$ représente la valeur maximale de l'efficacité quantique, en fonction de l'épaisseur de la couche d'espacement g, et pour un photodétecteur correspondant, pour les autres paramètres, à l'exemple de photodétecteur décrit plus haut.

De façon plus précise, pour la courbe $Q_1$, la valeur maximale de l'efficacité quantique est donnée pour une valeur de résonance de 4 080 nm.

La courbe $Q_1$ présente un pic pour une valeur de g sensiblement égale à 175 nm.

Pour une valeur de g égale à 500 nm, la valeur maximale de l'efficacité quantique représente environ 80% de la valeur correspondante pour une valeur de g égale à 175 nm.

La courbe $Q_2$ donne la valeur moyenne de l'efficacité quantique pour deux longueurs d'onde, l'une égale à 3 880 nm et l'autre à 4 280 nm.

Ces deux longueurs d'onde sont choisies de façon à être en dehors du pic de résonnance et plus particulièrement écartées de la valeur de la longueur d'onde de résonnance d'une valeur correspondant à sensiblement la largeur du pic de résonnance à mi-hauteur.

Cette courbe $Q_2$ correspond toujours à l'exemple de photodétecteur selon l'invention qui a été décrit précédemment, sauf en ce qui concerne la valeur de g qui varie.

Enfin, la courbe $Q_3$ est une courbe similaire à la courbe $Q_2$ mais pour un photodétecteur comportant un miroir sans structuration. Ce photodétecteur comporte par ailleurs, la même structure que le photodétecteur selon l'invention, ainsi que les mêmes matériaux constitutifs.

On constate que, entre les valeurs de g comprises entre $\lambda/12ne$ et $\lambda/3ne$, c'est-à-dire entre environ 125 et 500 nm, le photodétecteur selon l'invention diminue l'absorption dans la couche de semi-conducteur autour du pic de résonnance (courbe $Q_2$), par rapport à un photodétecteur comportant un miroir sans structuration (courbe $Q_3$).

Ceci montre que le photodétecteur selon l'invention permet d'améliorer la réjection spectrale.

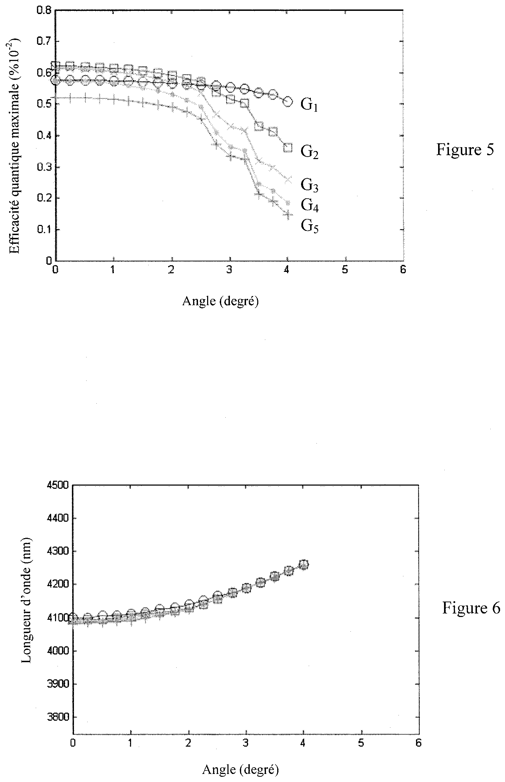

Il est maintenant fait référence à la figure 5 qui montre cinq courbes $G_1$ à $G_5$, ces courbes donnant la valeur maximale de l'efficacité quantique d'un photodétecteur selon l'invention, en fonction de l'angle de la lumière incidente, pour différentes valeurs de g.

Dans le cas de la figure 5, le photodétecteur est dimensionné selon l'exemple mentionné précédemment. Ainsi, la longueur d'onde de résonnance est située à 4 080 nm.

La courbe $G_1$ correspond à une valeur de g de 50 nm, la courbe $G_2$ à une valeur de g de 150 nm, la courbe $G_3$ à une valeur de g de 250 nm, la courbe $G_4$ à une valeur de g de 350 nm et enfin, la courbe $G_5$ à une valeur de g de 450 nm.

La figure 5 montre que, pour la courbe $G_1$, la valeur maximale de l'efficacité quantique du photodétecteur est pratiquement constante, pour un angle d'incidence compris entre 0 et 4°.

Pour des valeurs de g supérieures à 50 nm, les courbes $G_2$ à $G_5$ montrent que la valeur maximale de l'efficacité quantique diminue relativement peu pour un angle d'incidence compris entre 0 et 2°. Par contre, cette valeur diminue beaucoup plus rapidement, lorsque l'angle d'incidence est supérieur à 2°.

Ainsi, la figure 5 confirme qu'un photodétecteur selon l'invention présente une acceptance angulaire bien définie pour des valeurs de g supérieures à 50 nm.

Dans l'exemple illustré, cette acceptance angulaire est de l'ordre de 2°, ce qui correspond à environ 5° dans l'air.

Par ailleurs, cette figure confirme l'insensibilité angulaire du photodétecteur dans une gamme de ± 2°.

La figure 6 comporte trois courbes $G'_1$, $G'_2$ et $G'_4$.

Chacune d'elles donne la longueur d'onde correspondant à la valeur maximale de l'efficacité quantique, en fonction de l'angle d'incidence de la lumière et pour différentes valeurs de g.

Les valeurs retenues sont choisies parmi celles retenues pour les courbes $G_1$ à $G_5$. Ainsi, la courbe $G'_1$ (-○-) correspond à g = 50 nm, la courbe $G'_2$ (-□-) à g = 150 nm, et la courbe $G'_4$ (—●—) à g = 350 nm.

La figure 6 montre que la valeur de la longueur d'onde de résonnance se décale avec l'angle d'incidence. Cependant, ce décalage ne dépend pratiquement pas de la valeur de g. En effet, pour toutes les valeurs de g considérées, la longueur d'onde de résonnance se déplace d'environ 1% vers le rouge, pour des angles d'incidence compris entre 0 et 2°.

Ceci confirme donc les observations faites au regard de la figure 3.

La figure 7 comporte quatre courbes $T_1$ à $T_4$. Chacune d'elles représente l'efficacité quantique d'un photodétecteur selon l'invention, en fonction de la longueur d'onde, et pour différentes valeurs de l'indice ns du substrat.

La courbe $T_1$ correspond à une valeur de ns de 1, la courbe $T_2$ à une valeur ns de 1,5, la courbe $T_3$ à une valeur ns de 2 et la courbe $T_4$ à une valeur ns de 2,68.

Pour la courbe $T_4$, le photodétecteur considéré correspond à l'exemple décrit plus haut.

Pour les autres courbes, les valeurs de h et g sont constantes.

Cependant, la valeur de la largeur des fentes $L_3$ et $L_4$ et de la largeur d'un des reliefs $L_1$ sont ajustées pour que la valeur de la longueur d'onde de résonnance soit sensiblement identique pour les quatre courbes.

Les valeurs des différents paramètres sont indiquées de façon détaillée dans le tableau ci-dessous.

| ns | P | $L_1$ | $L_3 = L_4$ | $\lambda_{max}$ | $QE_{max}$ |
|------|------|------|------|------|------|
| 2.68 | 1490 | 740 | 125 | 4080 | 0.63 |
| 2 | 1725 | 862 | 145 | 4100 | 0.62 |
| 1.5 | 1950 | 973 | 160 | 4100 | 0.68 |
| 1 | 2250 | 1125 | 185 | 4100 | 0.69 |

Les courbes $T_1$ et $T_4$ montrent que la valeur maximale de l'efficacité quantique peut être augmentée d'environ 10% avec un photodétecteur ne comportant pas de substrat, l'indice correspondant étant celui de l'air.

Cette valeur de 10% est considérée par rapport à l'exemple de photodétecteur décrit plus haut pour lequel ns est égal à 2,68.

Cependant, cette augmentation est associée à une moins bonne réjection du photodétecteur.

La figure 8 est une vue de dessus d'un miroir comportant une structuration en deux dimensions.

La structuration illustrée consiste en un réseau de reliefs 80, 81 et 82 en forme de plots carrés et rectangulaires. La ligne en traits pointillés identifie un motif de la structuration, ce motif présentant la forme d'une cellule et étant répété selon la périodicité P.

De façon générale, ce réseau présente alors deux faisceaux croisés de lignes parallèles, en creux.

Un autre mode de réalisation, dans lequel la structuration ne consiste pas en des plots en relief sur la surface 130, mais en des trous formés à partir de cette surface, ne convient pas dans le cadre de l'invention.

Cette structuration en deux dimensions permet de rendre le photodétecteur indépendant de la polarisation.

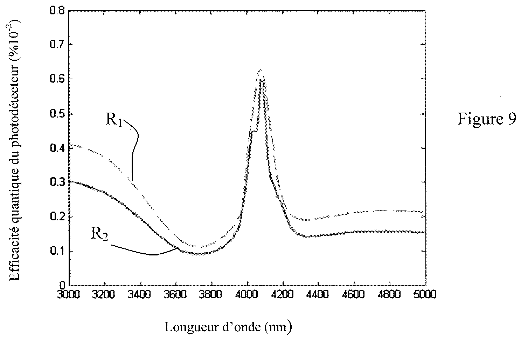

Il est maintenant fait référence à la figure 9 qui comporte deux courbes $R_1$ et $R_2$. Ces deux courbes illustrant l'efficacité quantique d'un photodétecteur, en fonction de la longueur d'onde, pour une lumière incidente perpendiculaire au photodétecteur et pour une température de fonctionnement de 77 K.

La courbe $R_1$ correspond à un photodétecteur selon l'invention dont le miroir est structuré en une dimension, conformément à l'exemple de photodétecteur décrit plus haut.

Ainsi, la courbe $R_1$ correspond à la courbe $C_1$ de la figure 2.

La courbe $R_2$ correspond, quant à elle, à un photodétecteur selon l'invention, répondant aux mêmes caractéristiques que l'exemple de photodétecteur décrit précédemment, sauf en ce qui concerne le miroir. En effet, la structuration du miroir est ici réalisée en deux dimensions. En d'autres termes, la périodisation du miroir est ici réalisée dans les deux directions du plan du miroir. Le miroir peut donc présenter une structuration telle qu'illustrée schématiquement à la figure 8.

La comparaison entre les courbes $R_1$ et $R_2$ montre que les deux types de photodétecteur conduisent à un renforcement de l'absorption qui est similaire.

On peut noter que l'absorption de fond est encore diminuée avec un photodétecteur comportant un miroir structuré en deux dimensions et que la réjection est donc augmentée.

Enfin, il convient de noter que le photodétecteur présente des avantages classiquement liés à la présence d'une couche mince de semi-conducteur. Il s'agit d'une diminution du volume de diffusion des porteurs photogénérés, qui limite le bruit d'obscurité du photodétecteur. En conséquence, la température de fonctionnement du photodétecteur peut être augmentée et le coût du système de refroidissement correspondant diminué.

Un autre avantage est l'augmentation de la bande passante de vitesse de détection, du fait de la taille réduite du photodétecteur.

Le photodétecteur infrarouge selon l'invention peut être utilisé dans de nombreuses applications. Il peut notamment s'agir de la sécurité des biens et des personnes (surveillance, caméra thermique pour la lutte contre le feu, évitement d'obstacles en conduite de nuit), détection de fuites et contrôle non destructif dans les installations industrielles (transport de fluide ou d'électricité, transport aérien et ferroviaire), contrôle environnemental (imagerie spatiale, diagnostic énergétique des bâtiments) et enfin, diagnostic médical (inflammations).

Les signes de référence insérés après les caractéristiques techniques figurant dans les revendications ont pour seul but de faciliter la compréhension de ces dernières et ne sauraient en limiter la portée.

## Revendications

**1.** Photodétecteur pour une radiation lumineuse infrarouge d'une longueur d'onde donnée ($\lambda$), **caractérisé en ce qu'**il comprend un empilement de couches avec :

- une couche continue (11) d'un matériau semi-conducteur partiellement absorbant, constituant la zone de photodétection,
- une couche (12) d'espacement en un matériau transparent à ladite longueur d'onde et d'indice ne, et
- un miroir métallique structuré (13) sous la forme d'un réseau, la distance (g) entre le sommet dudit miroir et la couche de semi-conducteur étant inférieure à $\lambda$/ne et la surface du miroir présentant un profil correspondant à la répétition périodique, selon la période (P), d'un motif élémentaire, défini par la succession alternée de reliefs (131, 132) et de fentes (133, 134), respectivement de premières largeurs $L_1$ et $L_2$ et de deuxièmes largeurs $L_3$ et $L_4$, les premières et deuxièmes largeurs $L_1$, $L_2$, $L_3$ et $L_4$ étant telles qu'aucune n'est nulle, leur somme est égale à la période (P) et au moins les premières largeurs sont différentes ($L_1 \neq L_2$) ou les deuxièmes largeurs sont différentes ($L_3 \neq L_4$).

**2.** Photodétecteur selon la revendication 1, dans lequel l'épaisseur e de la couche (11) de matériau semi-conducteur satisfait à la relation ——————— où kSC est la partie imaginaire de l'indice de réfraction dudit matériau semi-conducteur.

**3.** Photodétecteur selon la revendication 1 ou 2, dans lequel la profondeur (h) des fentes est comprise entre $\lambda$/12.nc et $\lambda$/5.nc, où nc est la partie réelle de l'indice du matériau présent dans les fentes (133, 134).

4. Photodétecteur selon l'une quelconque des revendications 1 à 3, comportant, sur la couche (12) de matériau semi-conducteur, un substrat transparent à ladite longueur d'onde et d'indice de réfraction ns.

5. Photodétecteur selon la revendication 4, dans lequel la période (P) est égale à λ/neff, où neff est compris entre min (ns, ne, nSC) et max (ns, ne, nSC) où nSC est la partie réelle de l'indice de réfraction dudit matériau semi-conducteur.

6. Photodétecteur selon l'une quelconque des revendications 1 à 5, dans lequel la largeur ($L_1$, $L_2$) d'un des reliefs (131, 132) est comprise entre $P/2-L_3$ et $2P/3-L_3$ et la largeur ($L_3$, $L_4$) des fentes (133, 134) est comprise entre λ/15.ne et λ/5.ne.

7. Photodétecteur selon l'une quelconque des revendications 1 à 6, dans lequel la distance (g) est comprise entre λ/15.ne et λ/3.ne.

8. Photodétecteur selon l'une quelconque des revendications 1 à 7, dans lequel l'indice ne est supérieur à nSC/2, où nSC est la partie réelle de l'indice de réfraction dudit matériau semi-conducteur.

9. Photodétecteur selon l'une quelconque des revendications 1 à 8, dans lequel le réseau dudit miroir (13) présente un faisceau de lignes en creux.

10. Photodétecteur selon l'une quelconque des revendications 1 à 8, dans lequel le réseau dudit miroir (13) présente deux faisceaux croisés de lignes en creux.

11. Photodétecteur selon l'une quelconque des revendications 1 à 10, dans lequel le matériau semi-conducteur est choisi parmi Si, Ge, SiGe, InAs, InSb, GaSb, PbS, PbSe, PbTe ou $Cd_xHg_{1-x}Te$ (avec x<0,9), des alliages ternaires comme InGaAs, AlInAs, AlInSb, InAsSb ou InGaSb, des alliages quaternaires comme InGaAsP ou InGaAsSb et des alliages quinaires comme GaInAsSb ou GaInAsSbP, ou encore un superréseau de type II.

12. Photodétecteur selon l'une quelconque des revendications 1 à 11, dans lequel le matériau de la couche d'espacement (12) est choisi parmi ZnS, CdTe ou des matériaux III-V.

**Patentansprüche**

1. Fotodetektor für eine Infrarot-Lichtbestrahlung in einer bestimmten Wellenlänge (A), **dadurch gekennzeichnet, dass** er einen Schichtenstapel umfasst mit:

- einer kontinuierlichen Schicht (11) aus einem teilweise absorbierenden Halbleitermaterial, das die Fotodetektionszone bildet,
- einer Abstandsschicht (12) aus einem für die Wellenlänge transparenten Material und mit Index ne, und
- einem netzwerkartig strukturierten Metallspiegel (13), wobei der Abstand (g) zwischen der Spitze des Spiegels und der Halbleiterschicht kleiner als λ/ne ist und die Oberfläche des Spiegels ein Profil aufweist, das der periodischen Wiederholung gemäß der Periode (P) eines elementaren Profils entspricht, definiert durch die alternierende Abfolge von Reliefs (131, 132) und von Schlitzen (133, 134) jeweils mit ersten Breiten $L_1$ und $L_2$ und mit zweiten Breiten $L_3$ und $L_4$, wobei die ersten und zweiten Breiten $L_1$, $L_2$, $L_3$ und $L_4$ derart sind, dass keine null ist, wobei ihre Summe gleich der Periode (P) ist und mindestens die ersten Breiten unterschiedlich sind ($L_1 \neq L_2$) oder die zweiten Breiten unterschiedlich sind ($L_3 \neq L_4$).

2. Fotodetektor nach Anspruch 1, wobei die Dicke e der Halbleitermaterialschicht (11) die Relation ___ ___ erfüllt; wobei kSC der imaginäre Teil des Refraktionsindexes des Halbleitermaterials ist.

3. Fotodetektor nach Anspruch 1 oder 2, wobei die Tiefe (h) der Schlitze zwischen λ/12.nc und λ/5.nc inklusive ist, wobei nc der reale Teil des Indexes des Materials ist, das in den Schlitzen (133, 134) vorhanden ist.

4. Fotodetektor nach einem der Ansprüche 1 bis 3, aufweisend, auf der Halbleitermaterialschicht (12), ein für die Wellenlänge transparentes Material und mit Refraktionsindex ns.

5. Fotodetektor nach Anspruch 4, wobei die Periode (P) gleich λ/neff ist, wobei neff zwischen min (ns, ne, nSC) und max (ns, ne, nSC) inbegriffen ist, wobei nSC der reale Teil des Refraktionsindexes des Halbleitermaterials ist.

6. Fotodetektor nach einem der Ansprüche 1 bis 5, wobei die Breite ($L_1$, $L_2$) eines der Reliefs (131, 132) zwischen $P/2-L_3$ und $2P/3-L_3$ inklusive ist und die Breite ($L_3$, $L_4$) der Schlitze (133, 134) zwischen λ15.ne und λ/5.ne inklusive ist.

7. Fotodetektor nach einem der Ansprüche 1 bis 6, wobei der Abstand (g) zwischen λ/15.ne und λ/3.ne inklusive ist.

8. Fotodetektor nach einem der Ansprüche 1 bis 7, wobei der Index ne größer als nSC/2 ist, wobei nSC der reale Teil des Refraktionsindexes des Halbleitermaterials ist.

9. Fotodetektor nach einem der Ansprüche 1 bis 8, wobei das Netzwerk des Spiegels (13) ein hohles Linienbündel aufweist.

10. Fotodetektor nach einem der Ansprüche 1 bis 8, wobei das Netzwerk des Spiegels (13) zwei hohle gekreuzte Linienbündel aufweist.

11. Fotodetektor nach einem der Ansprüche 1 bis 10, wobei das Halbleitermaterial aus Si, Ge, SiGe, InAs, InSb, GaSb, PbS, PbSe, PbTe oder $Cd_xHg_{1-x}Te$ (mit x<0,9), ternären Legierungen wie InGaAs, AllnAs, AllnSb, InAsSb oder InGaSb, quaternären Legierungen wie InGaAsP oder InGaAsSb und quinären Legierungen wie GaInAsSb oder GaInAsSbP oder auch aus einem Supernetzwerk vom Typ II ausgewählt ist.

12. Fotodetektor nach einem der Ansprüche 1 bis 11, wobei das Material der Abstandsschicht (12) aus ZnS, CdTe oder aus Materialien III-V ausgewählt ist.

**Claims**

1. A photodetector for infrared light radiation having a given wavelength $(\lambda)$, **characterized in that** it comprises a stack of layers with:

- a continuous layer (11) of a partially absorbent semiconductor material constituting the photodetection zone;
- a spacer layer (12) of material that is transparent at said wavelength and of refractive index ne; and
- a structured metal mirror (13) formed as a grating, the distance (g) between the top of said mirror and the semiconductor layer being less than $\lambda$/ne and the surface of the mirror presenting a profile corresponding to periodically repeating a unit pattern at a period (P), the pattern being defined by an alternating succession of portions in relief (131, 132) and of slots (133, 134) of respectively first widths $L_1$ and $L_2$ and second widths $L_3$ and $L_4$, the first and second widths $L_1$, $L_2$, $L_3$ and $L_4$ being such that none of them is zero, their sum is equal to P, and at least the first widths are different $(L_1 \neq L_2)$ or the second widths are different $(L_3 \neq L_4)$.

2. A photodetector according to claim 1, wherein the thickness e of the layer (11) of semiconductor material satisfies the following relationship:

$$e \leq 0.7 \times \frac{\lambda}{4 \times \pi \times kSC}$$

where kSC is the imaginary part of the refractive index of said semiconductor material.

3. A photodetector according to claim 1 or claim 2, wherein the depth (h) of the slots lies in the range $\lambda$/12.nc to $\lambda$/5.nc, where nc is the real part of the index of the material present in the slots (133, 134).

4. A photodetector according to any one of claims 1 to 3, including, on the layer (12) of semiconductor material, a substrate that is transparent at said wavelength and that is of refractive index ns.

5. A photodetector according to claim 4, wherein the period (P) is equal to $\lambda$/neff, where neff lies in the range min (ns, ne, nSC) and max (ns, ne, nSC), where nSC is the real part of the refractive index of said semiconductor material.

6. A photodetector according to any one of claims 1 to 5, wherein the width $(L_1, L_2)$ of one of the portions in relief (131, 132) lies in the range (P/2)-$L_3$ and (2P/3)-$L_3$, and the widths $(L_3, L_4)$ of the slots (133, 134) lie in the range $\lambda$/15.ne to $\lambda$/5.ne.

7. A photodetector according to any one of claims 1 to 6, wherein (g) lies in the range $\lambda$/15.ne to $\lambda$/3.ne.

8. A photodetector according to any one of claims 1 to 7, wherein the refractive index ne is greater than nSC/2, where nSC is the real part of the refractive index of said semiconductor material.

9. A photodetector according to any one of claims 1 to 8, wherein the grating of said mirror (13) presents a bundle of recessed lines.

10. A photodetector according to any one of claims 1 to 8, wherein the grating of said mirror (13) presents two cross-bundles of recessed lines.

11. A photodetector according to any one of claims 1 to 10, wherein the semiconductor material is selected from Si, Ge, SiGe, InAs, InSb, GaSb, PbS, PbSe, PbTe or $Cd_xHg_{1-x}Te$ (with x<0.9), from ternary alloys such as InGaAsP, AllnAs, AllnSb, InAsSb, and InGaSb, from quaternary alloys such as InGaAsP and InGaAsSb, or from quinary alloys such as GaInAsSb or GaInAsSbP, or indeed a type II superlattice.

12. A photodetector according to any one of claims 1 to 11, wherein the material of the spacer layer (12) is selected from ZnS, CdTe, and III-V materials.

Figure 1

Figure 2

Figure 3

Figure 4

Figure 5

Figure 6

Figure 7

Figure 8

Figure 9

Figure 10

Figure 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005081782 A
- US 20090020701 A
- WO 2007054560 A

**Littérature non-brevet citée dans la description**

- **K.W. GOOSSEN et al.** *Appl. Phys. Lett.,* 19 Septembre 1988, vol. 53, 1027
- **J.Y. ANDERSSON et al.** *Appl. Phys. Lett.,* 12 Août 1991, vol. 59, 857
- **CUI DAFU et al.** *Infrared Phys.,* 1991, vol. 32, 53
- **ANDERSSON et al.** *J. Appl. Phys.,* 1992, vol. 171, 3600